# EUROPEAN PATENT APPLICATION

(11) **EP 1 482 566 A2**
(43) Date of publication of application: **01.12.2004**
(21) Application number: 03012081.0
(22) Date of filing: 28.05.2003
(51) Int. Cl.: H01L 33/00, H01L 25/075

(54) **Light emitting diode electrode structure and full color light emitting diode formed by overlap cascaded die bonding**

(71) Applicant: Hen, Chang Hsiu, Hsin-chu (TW)
(72) Inventor: Hen, Chang Hsiu, Hsin-chu (TW)
(74) Representative: TER MEER STEINMEISTER & PARTNER GbR

(57) **Abstract**

The present invention discloses a package and electrode structure of a light emitting diode and a light source of full color LED by using die bonding and packaging technology. A silicon dioxide film and a reflective metal layer of gold germanium or gold alloy, is formed around the chip or forming a grove around the die to decrease the electric field near the scribe line. Bonding pad(s) are formed on one side of the chip. In a near field application, a red, a blue and a green LED are die-bonded in cascade to get a white light or full color light. In a far field application, a yellow and a blue LED are die bonded in cascade on a board, in its side is another cascaded die bond of a red and a green LED to get white or full color light.

## Description

### CROSS-REFERENCE TO RELATED APPLICATIONS

This application is a continuation-in-part (CIP) of Chang's provisional US patent application No. 10/189,847, filed April 5, 2002, and US patent application No. 10/001,419, filed November 15, 2001, the full disclosure of which is incorporated herein by reference.

### BACKGROUND OF THE INVENTION

### 1. Field of the invention

The present invention relates to a package structure of semiconductor light emitted diodes (LED), and more particularly, to a package and electrode structure of LEDs suitable for overlap bonding the LEDs in cascade by chip direct bonding with transparent layer and reflected metal layer, and capable of generating a full color light or white light by mixing lights emitted from the overlap LEDs

### 2. Description of Relative Prior Art

Light emitted diode (LED) is a semiconductor light-emitting device, formed by a p-n junction, to transform electric power into a light source. LED has characteristics such as small volume, long life-time, low driving voltage, shock hardness, thermal stability, etc., suitable for applications which need to be thin and small, and used in traffic signals, back light source of LCD and other commercial products.

LED make use of variety of compound semiconductor such as III-V group materials, II -VI group materials, to form variety structures such as p-n junction, double-hetero-junction(DH) and quantum well(QW), which can be used to design red, orange, yellow, green, blue, violet LEDs and also infrared, ultraviolet in-visible light LEDs. Materials suitable for making high intensity LED over 1000mcd with wave length from long wave to short wave are AlGaAs, InGaAIP and InGaN, etc.

By changing the semiconductor materials and device structures, LEDs with different visible and invisible colors can be designed, wherein AIGaAs, InGaAIP and InGaN are suitable for producing LEDs with high luminance over 1000 mcd.

When producing red or infrared LEDs with high luminance by AlGaAs, an LPE (Liquid Phase Epitaxy) process and DE (Double Epitaxy) structure devices are used for industrial mass production.

InGaAIP can be used to produce red, orange, yellow and yellow-green LEDs, and an MOVPE (Metal Organic Vapor Phase Epitaxy) process, double hetero (DH) junction structures, and quantum well (QW) structures are provided in efficient mass production.

InGaN is suitable for producing green, blue and ultra-violet LEDs with high luminance by high temperature MOVPE processes, wherein DH structures and QW structures are used, too.

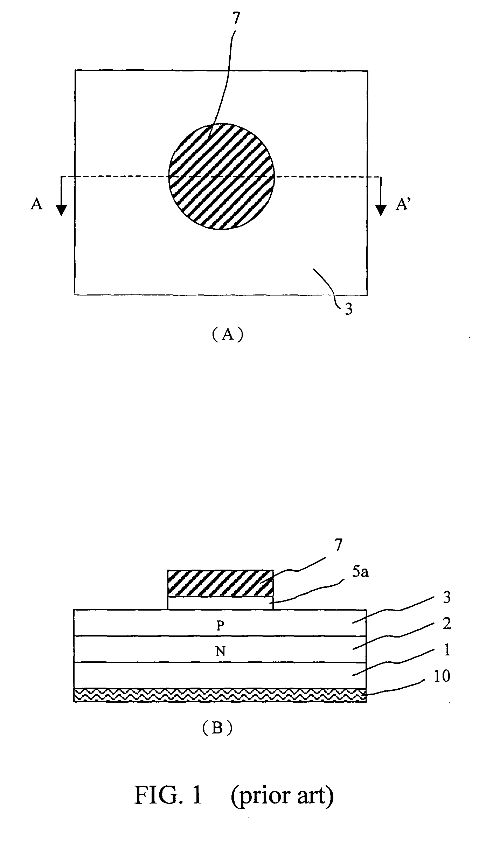

FIG.1 shows a conventional LED structure. FIG. 1A is the top view, and FIG. 1B is the cross sectional view of AA'. On a substrate **1** (normally is n-type GaAs, GaP or GaN), n-type semiconductor **2** and p-type semiconductor 3 are epitaxied to form a p-n junction. A thin layer of gold (Au) or AuGe alloy **5a** forms a round shaped ohmic contact on the center of the chip, then aluminum (Al) bonding pad **7** is deposited for wire bonding. A metal electrode **10** is deposited on the backside of the substrate as the negative electrode. Gold wire connects the positive electrode to the aluminum-bonding pad 7.

The electrode of a conventional LED on the center makes the electric field spreading uniformly around the chip, but gold and aluminum is opaqueness, light is blocking by the electrode too much if the electrode is large, but if too small, electric field would crowded in the center and the current density is increasing, this causes short life time of the LED, also in the center there will be a dark area which is obvious for near field observation; Also this electrode can not be used in overlap cascaded package.

Another disadvantage of the convention electrode structure of a LED is that the lattice defect caused by cutting the chip along the scribe line. The electric field spreads from the electrode **7** via the p-type semiconductor to the substrate. Current will crowd easily at the lattice defect and form light spots, which also hurt the junction and cause decreasing of lifetime. So it is needed to develop an electrode structure for LEDs to get longer lifetime, suitable for overlap cascaded packaging.

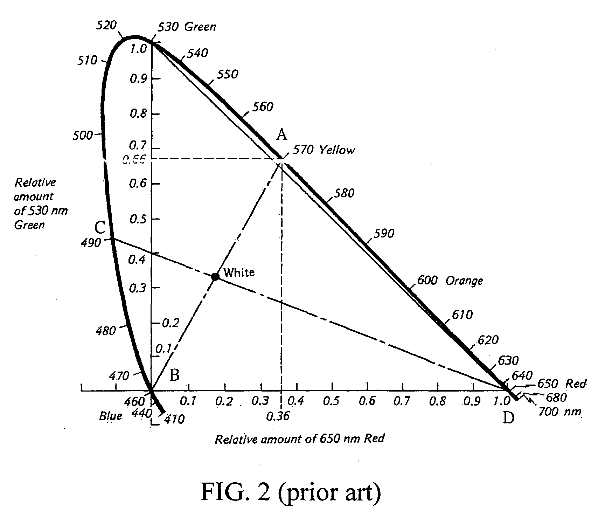

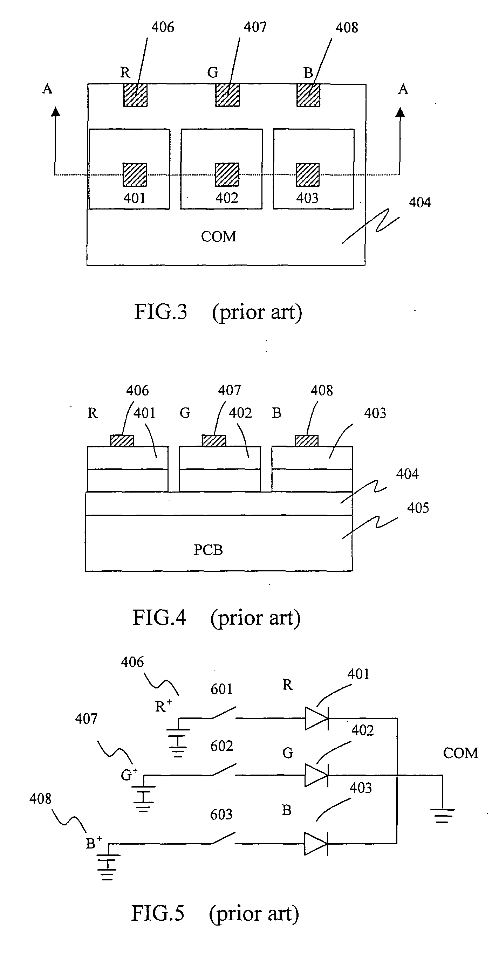

In order to get colors other than red, green and blue light by adjusting the intensity of the primary color of red, green and blue lights as shown in the chromaticity diagram in FIG.2. In the figure, if we adjust the blue and yellow light intensity along line AB, we shall have a white light in the intersection of line AB and CD; apart from the intersection and near point B we have bluish color. If there are red, blue and green primary colors, by adjusting the intensity of each color, we shall have a full color light source. As shown in FIG.3 and FIG.4, a conventional method of forming a full color LED, a red, a green and a blue primary color LEDs are packaged with chips 401, 402 and 403 in a row or in array by die bond on a PC board 405. The power of the red LED is apply to the positive pad 406 and via the ground pad 404 on the PC board 405 to the negative of the source, the same method is apply to the green and blue LEDs. FIG.5 is the equivalent circuit of the bias method of FIG.4. Generally, a constant current source of 20mA is used as the power source as shown in FIG.5, but the voltage is different for the diodes of different colors.

For example, 20mA with voltage of 2V is applied to the red LED 401; 20mA with voltage of 3.5V is applied to the green LED 402 and 20mA with voltage of 3.5V is applied to the blue LED 403, a white light is obtained and the power consumption is 180mW (20x2 + 20x3.5 + 20x3.5 = 180mW); if full color is needed, the current is still kept at 20mA, but by control the lighting period of each LED to combined the light to obtain different colors. The control accuracy is difficult to obtain, and the design of the power control IC is complicated, more ever, for constant current, much heat generated and heat dispersion is not easy, it causes short life-time of the LED. In near field observation, three colors is still observed, full color can be observed only for far field observation, so it does not satisfy the need of the market.

### SUMMARY OF THE INVENTION

The object of the present invention is to provide an electrode structure of light emitted diode with decreasing electric field intensity around the periphery of the chip and increasing the lifetime of the LED.

Another object of the present invention is to provide an electrode structure of light emitted diode with reflective metal around the chip to enhance the light emitting efficiency by reflecting the light emitted from the p-n junction to the reflective layer under the chip, and reflecting upward again. This makes the light emitted efficiently and there is no light emitted from the opaque region but only from the open window. If there is another LED with different color, overlap cascade bonded on the chip, the two colors may mix to form a mixed color such as white light if the two colors are complementary. No light without mixed is emitted alone and form a noise.

Another object of the present invention is to provide an electrode structure of light emitted diode, using sapphire as the substrate, and the positive and negative electrodes are both on the front side. The transparent conductive or non-conductive layer on the backside of the substrate is used for die bonding only, and let the light comes from the bottom LED transmit upward to mix with the light of the upper LED to form a mixed light.

Another object of the present invention is to provide an overlap cascaded packaging structure of a full color semiconductor LED to satisfy near field or far field display application.

Yet another object of the present invention is to provide a light source with metal oxide transparent conductive layer or transparent non-conductive layer to die bond the multi-chip to form overlap cascaded packaging structure. The structure has good resolution and is satisfied for both near field or far field observation.

In order to achieve the above objects and improve the disadvantage of a conventional structure of LED, four embodiments are presented. The full color LED packaging structure for overlap bonding in cascade, comprising: A substrate formed by GaAs, GaP, used as epitaxial substrate; A p-n junction of light emitted diode, epitaxied on said substrate; A silicon dioxide film and a reflective metal layer of gold germanium or gold alloy, is formed around the chip to decrease the electric field near the scribe line and formed an open window on the center such that light can emit from said window; A transparent conductive layer formed on said p-type semiconductor, said silicon dioxide layer and said reflective metal layer such that positive bias voltage is applied to the p-type semiconductor uniformly; A rectangular bonding pad formed by aluminum, aluminum alloy or gold, is formed on one side of the chip to be the positive bonding pad; A metal electrode formed on the bottom of said substrate to be a reflecting layer of light and a negative electrode, which may bond to a pc board or a lead frame.

In one aspect of the present invention, the silicon dioxide film and the reflective metal layer is replaced by etching a grove around the LED die.

In another aspect of the present invention, a transparent layer is formed on the bottom of said substrate to transmit the light from a bottom layer LED to mix with the light from an upper layer LED to form another color of light, and also used as a die bonding layer for overlap cascaded packaging.

In one aspect of the present invention, a full color LED packaging structure containing three-primary-color LED dice bond in cascade, by using a reflective metal layer and a transparent layer to overlap bond the red, blue and green LED dice in cascade on a bonding seat, comprising: (a) a bonding seat, wherein a reflective metal layer is deposited and patterned to form a die bonding pad, a red LED positive bonding pad, a blue LED positive bonding pad, a green light positive bonding pad and a common negative bonding pad; (b) a first red LED die having a transparent conductive layer of positive electrode and a reflective metal layer of negative electrode, the red LED die is directly overlap bonded to the die bonding pad of the bonding seat; (c) a second blue LED die having a transparent conductive layer of positive and negative electrode, the blue LED die is directly overlap bonded in cascade by transparent non-conductive layer on the red LED die; (d) a third green LED die having a transparent conductive layer of positive and negative electrode, the green LED die is directly overlap bonded in cascade by transparent non-conductive layer on the blue LED die; (e) a plurality of bonding wires for electrically connecting the positive and negative bonding pads of the red LED die, the blue LED die and the green LED die to the positive bonding pads and the common negative bonding pad on the bonding seat respectively.

Yet another aspect of the present invention provides a full color LED packaging structure containing a blue LED die on a yellow LED die in parallel side-by-side with another green LED die on a red LED die, the yellow LED die is bonded to a bonding seat and the blue LED die is overlap bonded in cascade to the yellow LED die, the red LED die is bonded to the bonding seat and the green LED die is overlap cascade bonded to the red LED die, comprising: (a) A bonding seat, wherein a reflective metal layer is deposited and patterned to form a die bonding pad, a red LED positive bonding pad, a blue LED positive bonding pad, a yellow LED positive bonding pad, a green LED positive bonding pad and a common negative bonding pad; (b) A first yellow LED die having a transparent conductive layer of positive electrode and a reflective metal layer of negative electrode, the yellow LED die is directly overlap bond to the die bonding pad of the bonding seat; (c) A second blue LED die having a transparent conductive layer of positive electrode and a reflective metal layer of negative electrodes, the blue LED die is directly overlap bonded in cascade by transparent non-conductive layer on the yellow LED die; (d) A third red LED die having a transparent conductive layer of positive and a reflective metal layer negative electrodes, the red LED die is directly overlap bonded to the die bonding pad of the bonding seat in one side nearby the yellow and blue LED dice; (e) A fourth green LED die having a transparent conductive layer of positive and a reflective metal layer negative electrodes, the green LED die is directly overlap bonded in cascade by transparent non-conductive layer on the red LED die; (f) A plurality of bonding wires for electrically connecting the positive and negative bonding pad of the yellow LED die, the blue LED die, the red LED die and green LED die to the positive bonding pads and the common negative bonding pad on the bonding seat respectively.

### BRIEF DESCRIPTION OF THE DRAWING

- FIG. 1A: (prior art) shows the top view of the electrode structure of an LED.
- FIG. 1B: (prior art) shows the cross section of the electrode structure of an LED along A-A' of FIG. 1A.
- FIG.2: (prior art) is a chromaticity diagram.
- FIG.3: (prior art) is the top view of a full color LED package with the three primary colors in a row of a prior art.
- FIG.4: (prior art) is the cross section along A-A line of FIG.3.
- FIG. 5: (prior art) is the equivalent circuit of the bias method of FIG.3.
- FIG.6: shows the electrode structure of an LED according to the first embodiment of the present invention.
- FIG.7A: is the cross section along B-B of FIG.6 with a silicon dioxide layer and a reflective metal layer.
- FIG.7B: is the cross section along B-B of FIG.6 with a grove around the die.
- FIG. 8A, B,: and C show the manufacturing steps of the electrode of an LED with a silicon dioxide layer and a reflective metal layer.
- FIG.8D, E, and F: show the manufacturing steps of the electrode of an LED with a grove around the die.
- FIG.9A: shows the top view of the electrode structure of an LED according to the second embodiment of the present invention.
- FIG. 9B: shows the cross section along A-A of FIG.9A.
- FIG.9C: shows the cross section along B-B of FIG.9A.
- FIG.10A: shows the top view of the electrode structure of an LED according to the third embodiment of the present invention.
- FIG. 10B: shows the cross section along A-A of FIG. 10A.
- FIG. 11A: shows the top view of an overlap cascaded three primary color dice packaging structure of a full color LED on a pc board suitable for near field observation in accordance with the present invention.
- FIG.11B: shows the top view of an overlap cascaded three primary color dice packaging structure of a full color LED on a lead frame suitable for near field observation in accordance with the present invention.
- FIG. 12: is the cross section view along A-A line of the full color LED in FIG. 11A.
- FIG. 13: is the cross section view along B-B line of the full color LED in FIG. 11A.
- FIG. 14: is the cross section view along C-C line of the full color LED in FIG. 11A.
- FIG.15A: is the equivalent circuit of the bias method of the full color LED in FIG. 11 using common cathode connection.
- FIG.15B: is the equivalent circuit of the bias method of the full color LED in FIG. 11 using common anode connection.
- FIG. 16: shows the overlap cascaded two chips in parallel packaging structure of the full color LED suitable for far field observation in accordance with the present invention.
- FIG. 17: is the cross section view along A-A line of the full color LED in FIG. 16.
- FIG. 18: is the cross section view along B-B line of the full color LED in FIG. 16.
- FIG.19: is the equivalent circuit of the bias method of the full color LED in FIG. 16.

### DETAIL DESCRIPTIONOF THE PRESENT INVENTION

Preferred embodiments of the present invention will be explained with refer to the accompanying drawings. The color, material and junction structure of the LED chip is not limited, any light emitted diode can use the electrode structure of the present invention. The electrode structure of the present invention is use in overlap cascaded structure packages of different color LED chips, by mixing two or three color light to have a different color light or white light.

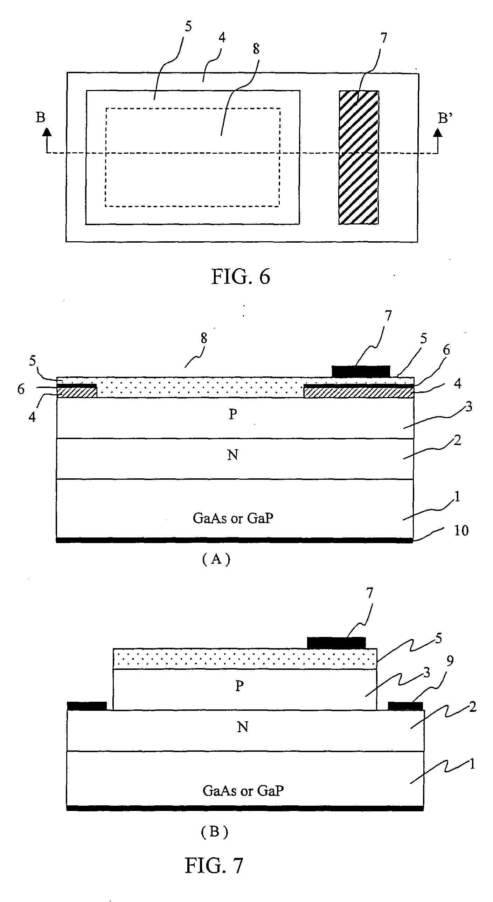

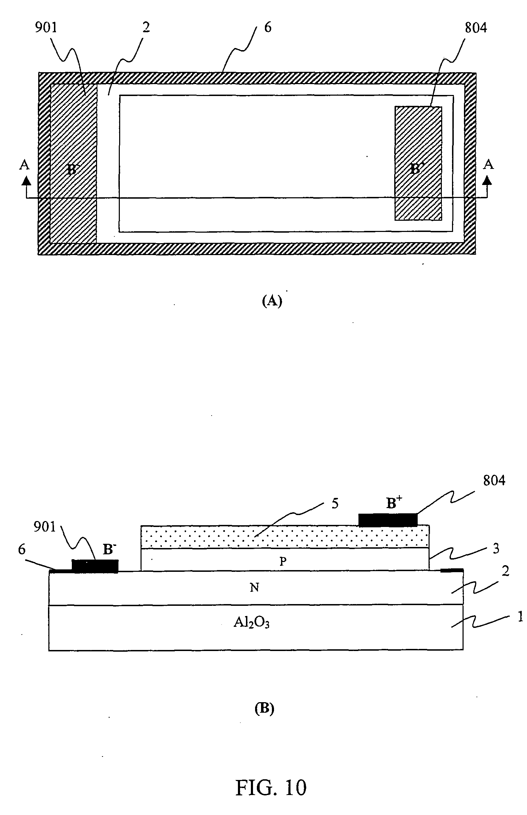

FIG.6 shows the electrode structure of a bottom LED die for overlap cascaded packaging of the first embodiment of the present invention. FIG.7 is the cross section along BB of FIG.6. Substrate **1** is III-V group compound semiconductor such as GaAs or GaP. In this figure, by using a p-n junction as the LED diode, but it is equivalent to use an n-p junction. One layer of n-type semiconductor **2** is formed by epitaxy on the substrate **1** (see the cross sectional view of FIG.7A and 7B). Then a p-type semiconductor **3** is expitaxied to form a p-n junction as the light emitted diode. The p-n junction may be double hetero structure or quantum well structure. An electrode structure of the present invention is formed on the p-type semiconductor. First, a silicon dioxide layer **4** of 200Å to 10000Å is deposited on the p-type semiconductor. Then a reflective metal layer **6** such as Cr, AuGe, Au or other gold alloys, with thickness of 200 Å to 5000Å, the better of 500 Å, is deposited on the oxide layer **4** and the semiconductor **3**, By using a first mask in lithography and etching process to etch away the oxide layer 4 and the reflective metal layer **6** to form an open window 8 and keep the silicon dioxide around the chip and under the bonding pad **7**. The width of the oxide layer **4** is 5-20µm around the chip, but under the positive bonding pad **7**, the width of the oxide layer **4** is larger than the metal bonding pad **7**, so that after the electrode is formed, the metal electrode **5**,**6**, the silicon dioxide layer **4** and the p-type semiconductor **3** will form a capacitor which will decrease the electric field intensity around the scribe line. Under this weaker electric field, the lattice defects caused by scribing will not extraordinary emit lights to form light spots, and the lifetime of the LED chip will increase. Next a transparent conductive layer **5** with thickness of 200Å to 10000Å, the better of 500 Å to 2000 Å, is deposited on the p-type semiconductor **3** and silicon dioxide **4** to form ohmic contact with the p-type semiconductor 3. When a positive voltage is applied on the p-n junction via the bonding pad, the reflective metal layer 6 and the transparent conductive layer **5**, light will emit through the open window of the reflective metal layer **6**. But if the light meets the reflective metal layer **6**, light is reflected back and upward again by the bottom reflective metal and emitted through the open window, which will increase the light efficiency. If there is another LED in overlap cascaded packaging on it, (refer to Fig. 10 for cascaded structure), all the light via the open window emitted to another LED will mix with the light of another LED. But around the periphery no light from the bottom LED is emitted without mixing with the sight from another LED, and noise may eliminate. The thickness of the reflective metal layer **6** and the transparent conductive layer **5** is thin, so that avoid pilling when scribing into chips. Finally bonding pad **7** is deposited on the reflective metal **6** and formed on one side of the chip (the right side of FIG.6 and FIG.7) The bonding pad **7** is a strip of Al, aluminum alloy, Au, or, gold alloys with thickness of 1000Å to 40000Å, the better of 10000Å, which is thicker than the transparent conductive layer **5** and the reflective metal layer **6**, for aluminum wire or gold wire boding. A metal negative electrode **10** is formed on the bottom of the substrate to be the negative electrode, which can be bonded to a PC board or a bonding seat of a lead-frame, also to be a reflective layer to reflect lights upward.

The electrode structure as described above with electrode **7** on one side of the chip, around the chip there is a reflecting metal layer **6** to reflect the light except the open window **8**, the light can emit from the open window **8** through the transparent conductive layer **5**, thus the conversion efficiency of light will increase, and there will be no light without mixing coming out as a noise. Also the silicon dioxide **4** around the chip and under the bonding pad 7 will decrease the electric field intensity along the scribe line, so that the lattice defect induced by scribing will not extraordinary emit lights to form light spots, and the lifetime of the LED chip will increase. The oxide under the bonding pad **7** forms a soft seat to absorb the stress of wire bonding without hurting the pn-junction and forming defects under the bonding pad **7**.

FIG.7B shows another embodiment of the present invention. Instead of forming the silicon dioxide layer 4 and the reflective metal layer 6, the electric field intensity along the scribe line can be formed by etching away a grove 9 of the transparent conductive layer 5 and the p-type semiconductor 3 around the die. This also decrease the electric field intensity along the scribe line, so that the lattice defect induced by scribing will not extraordinary emit lights to form light spots, and the lifetime of the LED chip will increase.

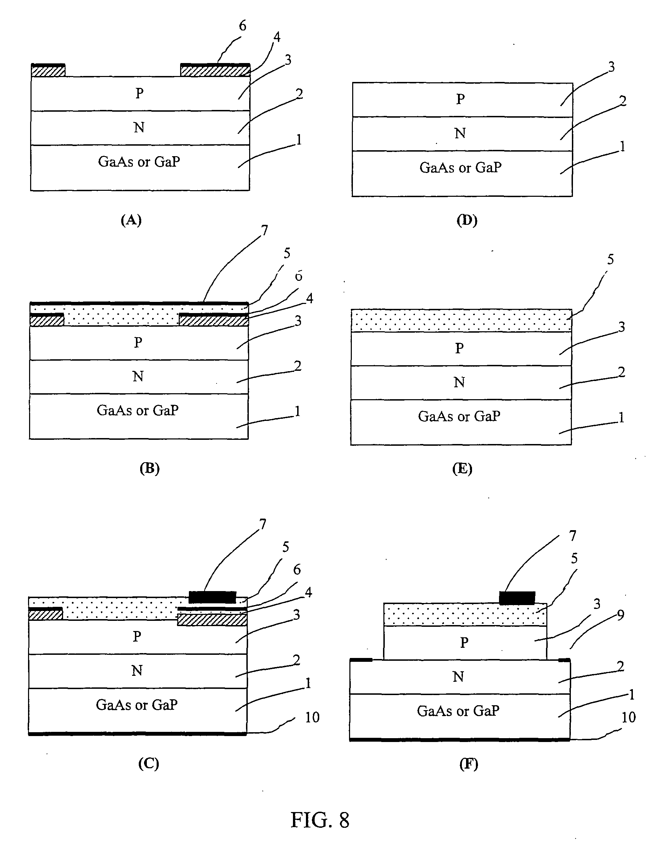

Fig.8 shows the manufactory steps of the electrode of LED of the first embodiment of the present invention. As shown in Fig.8A, n-type semiconductor **2** and p-type semiconductor **3** are epitaxied on substrate **1** to form a p-n junction, silicon dioxide layer **4** with thickness of 200Å to 10000Å is deposited on the p-type semiconductor **3**, a reflective metal layer **6** of Cr, AuGe, Au or other gold alloy with thickness of 200Å to 5000Å, the better of 500Å is deposited, lithography and etching step is performed with a first mask to remove the oxide layer 4 and the reflective metal layer **6** except that around the chip and that under the bonding pad **7**, The width of the oxide **4** is 5-20µm around the chip, but under the positive bonding pad **7**, the width of the oxide layer **4** is larger than the bonding pad **7** to release the stress of wire bonding. Then as in Fig.8B, a transparent conductive layer **5** with thickness of 200Å to 10000Å, the better of 500Å to 1000Å to be deposited, next a layer of Al or aluminum alloy is deposited to form the bonding pad **7**. Then as in Fig.8C, by using a second mask, lithography and etching or lift-off process steps to form the bond pad **7**. Finally, metal such as Al, aluminum alloy or gold is deposited on the bottom of the substrate to form a negative electrode **10**.

FIG. 8D, E, and F show the manufacturing steps of the electrode of an LED with a grove around the die. As shown in Fig.8D, n-type semiconductor **2** and p-type semiconductor **3** are epitaxied on substrate **1** to form a p-n junction, Then as in Fig. 8E, a transparent conductive layer **5** with thickness of 200Å to 10000Å, the better of 500Å to 1000Å to be deposited, Then as in Fig.8F, lithography and etching step is performed with a first mask to etch a grove of the transparent conductive layer **5** and the p-type semiconductor **3** around the die. The width of transparent conductive layer and p-type semiconductor removed around the die is 10 µm to 50 µm.

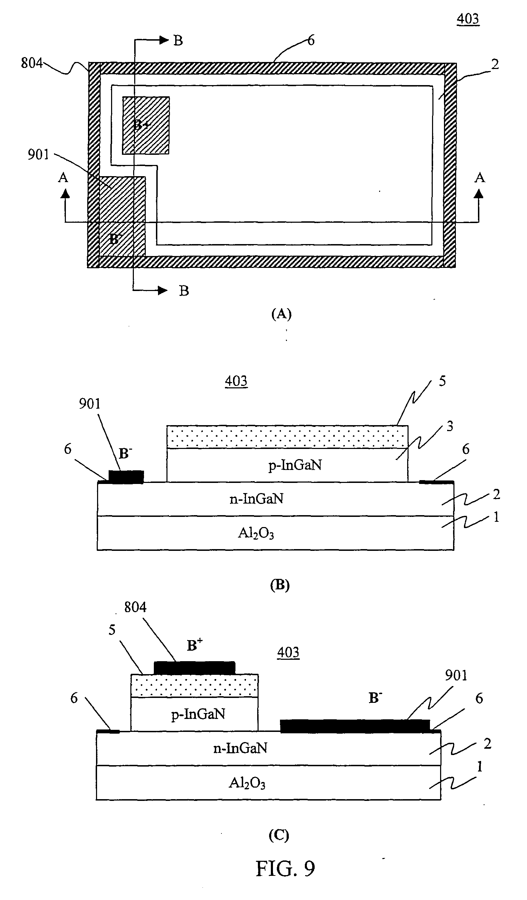

FIG.9A shows the top view of the structure of an LED die used for overlap cascaded packaging in accordance with one embodiment of the present invention. FIG. 9B is the cross sectional view along A-A line of the full color LED in FIG.9A. FIG.9C is the cross sectional view along B-B line of the full color LED in FIG.9A. In these figures, by using a pn junction as the LED diode, but it is equivalent to use an np junction. In FIG.9A, a blue light (for example) LED chip 403 is made by epitaxy n-type InGaN 2 on a transparent sapphire substrate 1, then a p-type InGaN 3 is epitaxied on the n-type InGaN 2 to form a pn junction, The epitaxial is carry out by MOVPE(Metal Organic vapor Phase Epitaxy) technology. A transparent conductive layer 5 with thickness of 200Å to 10000Å, the better of 500Å to 1000Å, is sputtered or evaporated to be the positive electrode. On one side on the top of the chip, a metal strip 804 of aluminum, copper or gold with width of 50 *µ*m to 200 *µ*m, the better of 100 µ m and thickness of 1000Å to 40000Å, the better of 10000Å is deposited to be the positive bonding pad of the blue light LED chip. Then by using a first mask to perform lithography and etching away a grove of the transparent conductive layer 5 and the p-type InGaN layer 3 to expose the n-type InGaN 2. Then a thin electrode layer 6 of metal such as Cr, Au or Al with width of 5-20 *µ*m, and thickness of 200Å to 10000Å, the better of 500Å is deposited to be the negative conducting metal 6, also a thick metal strip 901 of aluminum, copper or gold with width of 50 µm to 200 µ m, the better of 100 µ m and thickness of 1000Å to 40000Å, the better of 10000Å is deposited be the negative bonding pad 901. The negative bonding pad 901 is line up with the positive bonding pad 804 in one side of the chip. The reflective metal layer 6 prevent the light emit without mixing and conducting current around the chip to reduce the series resistance of the n-type InGaN, so that the driving voltage can be reduced. The thickness of the thin electrode layer 6 is very thin such that scribing along the scribe line will not damage the metal and the n-type crystal. Since in such structure, the p-n junction under the transparent conductive layer 5 keep away from the scribe line, so that the lattice defects induced by scribing will not extraordinary emit lights to form light spots, and the life time of the LED chip will increase, as shown in FIG.9C.

FIG.10A shows the top view of the structure of an LED die used for overlap cascaded packaging in accordance with one embodiment of the present invention. The structure is the same as in FIG.9A except that the metal strip of positive electrode 804 is on the opposite site of the negative electrode 901. FIG 10B is the cross sectional view along A-A line of FIG. 10A. The strip electrode can be made as a square for saving chip area.

Hereunder, one embodiment of an overlap cascaded three primary color dice packaging structure of a full color LED according to the present invention is described with reference to the attached drawings.

The LED dice used in this invention can be made with different type of material. The dice can be made by conventional method in accordance with the specification of this invention such as chip size, bias voltage, intensity, color and metal contact, etc. The dice should be tested and classified before packaging.

In the following embodiments, a pc-board or lead-frame with reflective metal pattern on the pc-board for die bonding, after the first chip is bond on the pc-board, a second chip is overlap and cascade bonded on the first chip. Bonding can be thermal, ultrasonic or transparent epoxy, polyimide or other transparent materials adhesion. A third chip is also over lap and cascade bonded on the second chip. Wire bond is then connected the positive electrode to the power source and the negative electrode to common ground.

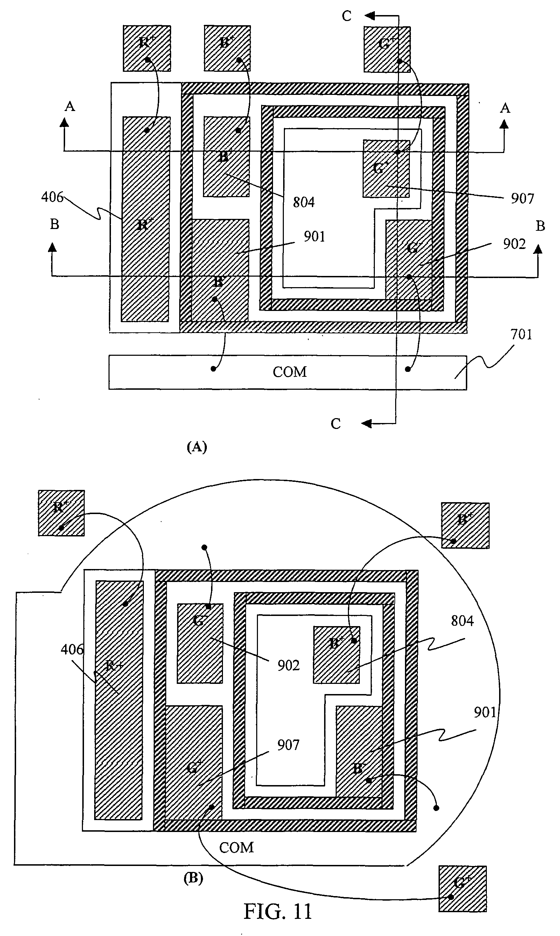

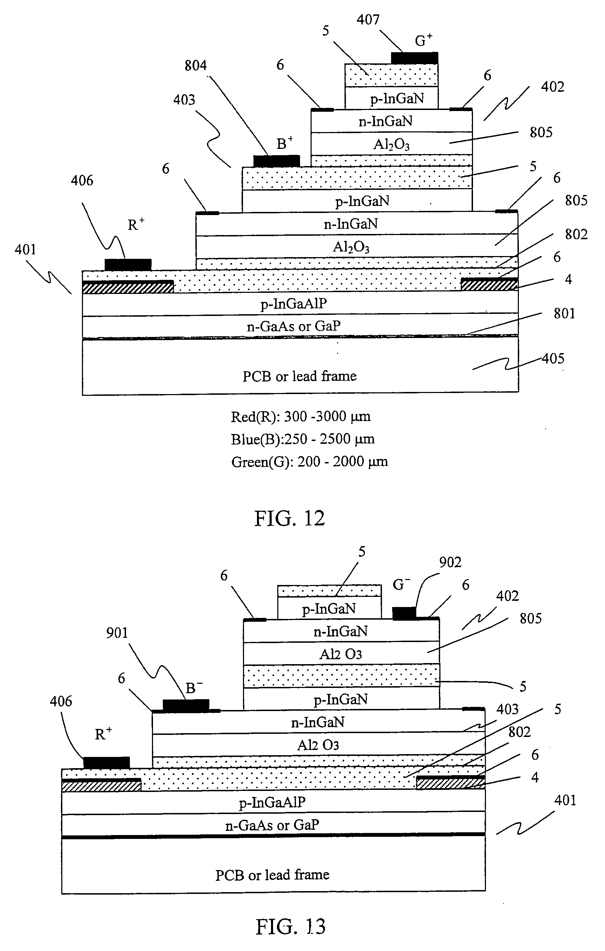

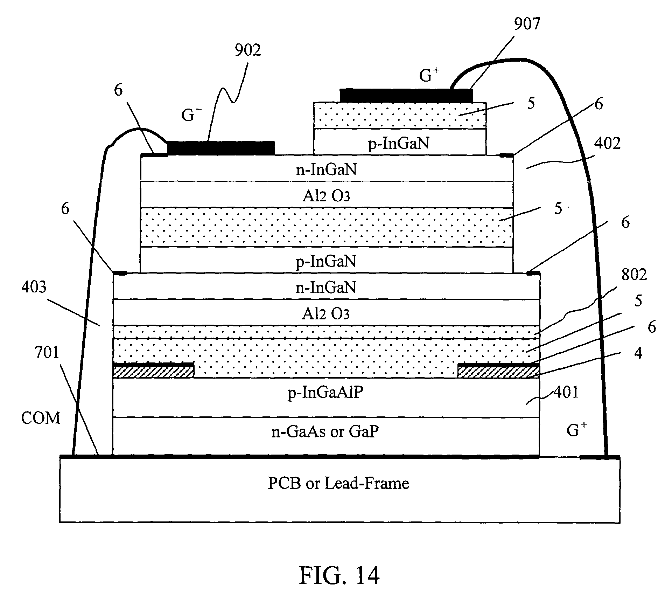

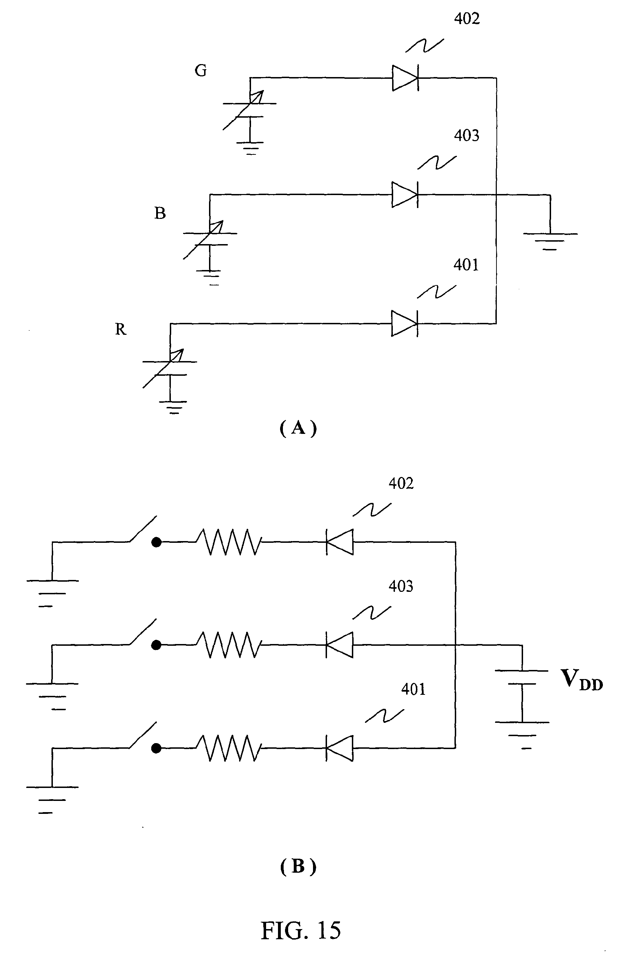

FIG.11A and B shows the top view of an overlap cascaded three primary dice packaging structure of a full color LED suitable for near field observation in accordance with one embodiment of the present invention. FIG. 11A shows the plane view of a full color LED packaging on a pc board and FIG.11B shows the plane view of a full color LED packaging on a lead-frame. FIG. 12 is the cross section view along A-A line, and FIG. 13 is the cross section view along B-B line and FIG.14 is the cross section view along C-C line of the full color LED in FIG. 11A. In these figures, by using a p-n junction as the LED diode, but it is equivalent to use an np junction. First, prepare a red light LED chip 401, which is made by conventional method to form p-type InGaAIP/n-type GaAs (or GaP) pn junction, a layer of aluminum, copper or gold with thickness of 1000Å to 40000Å, the better of 2000Å to 10000Å, is sputtered or evaporated on the bottom of the chip, then a transparent conductive layer 5 with thickness of 200Å to 10000Å, the better of 500Å to 1000Å, is sputtered or evaporated to be the positive electrode. Then by using a first mask to perform lithography and etching away a grove of the transparent conductive layer 5 and the p-type InGaN layer 3 to expose the n-type InGaN 2. Then a thin electrode layer 6 of metal such as Cr, Au or Al with width of 5-20 µ m, and thickness of 200Å to 10000Å, the better of 500Å is deposited to be the negative conducting metal 6, also a thick metal strip 901 of aluminum, copper or gold with width of 50 *µ* m to 200 µm, the better of 100 µm and thickness of 1000Å to 40000Å, the better of 10000Å is deposited be the negative bonding pad 901. The negative bonding pad 901 is line up with the positive bonding pad 804 in one side of the chip. On one side on the top of the chip, a strip of metal layer 406 with width of 50 *µ*m to 200 *µ*m, the better of 100 *µ*m, is deposited to be the positive bond pad, this prevent the red light emit without mixing with the other color light and become noise signal, and also reflect the red light to the reflective layer 801 then reflect upward again to mix with the other color light, so that the energy of the red light can be used completely. This layer also conducts current around the chip to reduce the series resistance of the n-type InGaN, so that the driving voltage can be reduced. The thickness of the thin electrode layer 6 is very thin such that scribing along the scribe line will not damage the metal and the n-type crystal. Since in such structure, the p-n junction under the transparent conductive layer 5 keep away from the scribe line, so that the lattice defects induced by scribing will not extraordinary emit lights to form light spots, and the life time of the LED chip will increase. The size of the red light LED chip 401 is about 300 µm to 3000 µm. The red light LED 401 is then bonding to a pc-board or a lead-frame 405 by heating to the eutectic point of metal, for example, 450° C to 550° C, or by ultrasonic bonding or silver paste adhesion. The reflective metal layer on the bottom of the chip is then connected to the common ground pattern 801 (it is also the ground electrode of the red light LED) of the pc-board or lead-frame. A second blue light LED chip 403 is made by epitaxy n-type InGaN on a transparent sapphire substrate 805, then a p-type InGaN is epitaxied on the n-type InGaN to form a pn junction, The epitaxial is carry out by MOVPE technology. Then a transparent conductive layer 5 with thickness of 200Å to 10000Å, the better of 500Å to 1000Å, is sputtered or evaporated to be the positive electrode. By using a first mask to perform lithography and etching away a grove of the transparent conductive layer 5 and the p-type InGaN layer 3 to expose the n-type InGaN 2. Then a thin electrode layer 6 of metal such as Cr, Au or Al with width of 5-20 µm, and thickness of 200Å to 10000Å, the better of 500Å is deposited to be the negative conducting metal 6, also a thick metal strip 901 of aluminum, copper or gold with width of 50 µ m to 200 µm, the better of 100 µ m and thickness of 1000Å to 40000Å, the better of 10000Å is deposited be the negative bonding pad 901. The negative bonding pad 901 is line up with the positive bonding pad 804 in one side of the chip. On one side on the top of the chip, a metal strip 804 of aluminum, copper or gold with width of 50 *µ*m to 200 µm, the better of 100 *µ*m and thickness of 1000Å to 40000Å, the better of 10000Å is deposited to be the positive bonding pad of the blue light LED chip. The reflective metal layer 6 prevent the mixed blue and red light emit without mixing with the green light and become noise signal, and also reflect the blue and red light to the reflective layer on the pc-board upward again to mix with the green light, so that the energy of the blue and red light can be used completely. This layer also conducts current around the chip to reduce the series resistance of the n-type InGaN, so that the driving voltage can be reduced. The thickness of the thin electrode layer 6 is very thin such that scribing along the scribe line will not damage the metal and the n-type crystal. Since in such structure, the p-n junction under the transparent conductive layer 5 keep away from the scribe line, so that the lattice defects induced by scribing will not extraordinary emit lights to form light spots, and the life time of the LED chip will increase, as shown in FIG. 11, FIG. 12 and FIG. 13. The size of the blue LED chip is about 250 µm to 2500 µ m. The blue LED chip 403 is overlap cascade bonded to the red LED chip 401 by a layer of transparent but non-conductive material such as epoxy, polyimide or other transparent materials adhesion. A third green LED chip 402 is also made by epitaxy an n-type InGaN and p-type InGaN on a transparent sapphire substrate 805, which can be made by a traditional technology. Then a transparent conductive layer 5 with thickness of 200Å to 10000Å, the better of 500Å to 1000Å, is sputtered or evaporated to be the positive electrode. By using a first mask to perform lithography and etching away a grove of the transparent conductive layer 5 and the p-type InGaN layer 3 to expose the n-type InGaN 2. Then a thin electrode layer 6 of metal such as Cr, Au or Al with width of 5-20 µ m, and thickness of 200Å to 10000Å, the better of 500Å is deposited to be the negative conducting metal 6, also a thick metal strip 902 of aluminum, copper or gold with width of 50 µ m to 200 µ m, the better of 100 µ m and thickness of 1000Å to 40000Å, the better of 10000Å is deposited be the negative bonding pad 902. The negative bonding pad 902 is line up with the positive bonding pad 907 in one side of the chip. The reflective layer 902 and 907 reflect the blue and red light to prevent the mixed blue and red light emit without mixing with the green light to become noise signal, and also reflect the mixed blue and red light so that the blue and red light can be used completely, This layer also conducts current around the chip to reduce the series resistance of the n-type InGaN, so that the driving voltage can be reduced. The thickness of the thin electrode layer 6 is very thin such that scribing along the scribe line will not damage the metal and the n-type crystal. Since in such structure, the p-n junction under the transparent conductive layer 5 keep away from the scribe line, so that the lattice defects induced by scribing will not extraordinary emit lights to form light spots, and the life time of the LED chip will increase, as shown in FIG. 12, FIG. 13 and FIG.14. The size of the green LED chip 402 is about 200 µ m to 2000 µ m. Then the green LED chip 402 is overlap bonded in cascade to the blue LED 403 by a layer of transparent but non-conductive material such as epoxy, polyamide or other transparent materials adhesion, as shown in FIG.12, FIG. 13 and FIG. 14. Wire bond is then connect the red, blue and green LED positive bonding pad R+, B+ and G+ to the positive bonding pad of the red, blue and green light on the pc board or lead frame respectively, and the negative pad B-, G- of the blue and green LED to the common ground 701 on the pc-board or lead frame, as shown in FIG. 11 and FIG. 14. The full color LED is then sealed with transparent plastic material. The package of this embodiment is then completed. The equivalent circuit is shown in FIG. 15A or B, where FIG. 15A is for common cathode of the electrical circuit and FIG.15B is for common anode of the electrical circuit. It is value to notice that in this embodiment, different color is obtained by changing the bias of each color to change the current and thus different light intensity is mixed to form different color as shown in the chromaticity diagram of FIG.2. This not only can save energy but also improve the resolution and quality of the color. Moreover, it needs not high current to emit light, the heat generated is less, and heat dissipation is good. The life time of the LED chips can be increased.

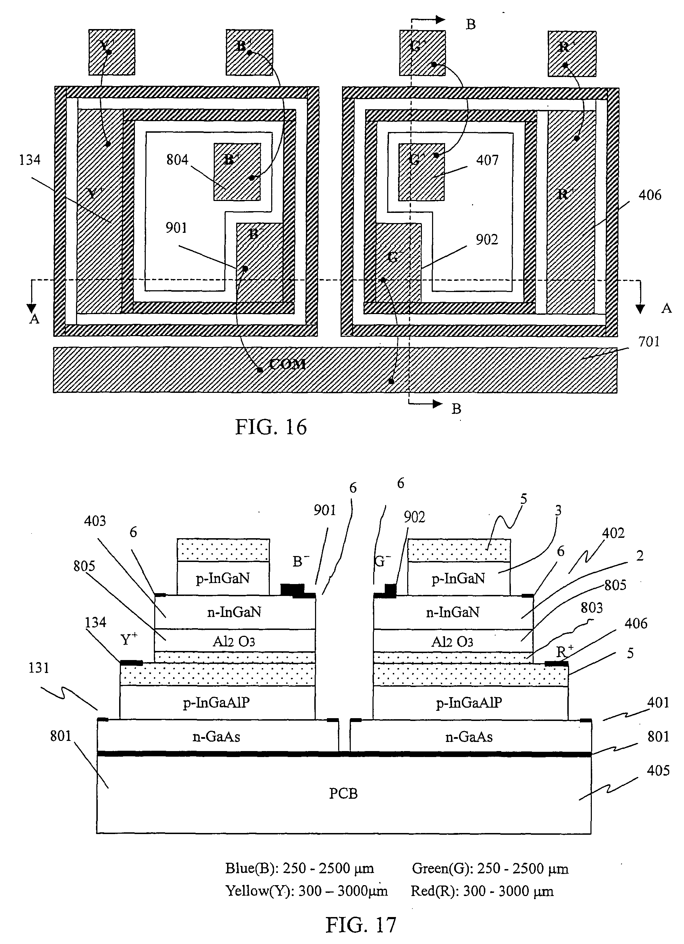

Another embodiment of a full color LED packaging structure in accordance with the present invention is made by overlap cascaded bonding of a yellow and a blue light LEDs in parallel with another overlap cascaded red and green light LEDs. This structure is suitable for far field observation and is described in FIG.16 and FIG.17. FIG. 16 is the plane view. FIG.17 is the cross section along A-A line in FIG. 16. In order to simplify die bond and save energy, we do not use three primary color LEDs, instead we use only two LEDs in overlap cascaded, then package in parallel side-by-side with another two LEDs in overlap cascaded. This structure satisfies far field observation. Refer to FIG. 17, which is using p-n junction dice in the present embodiment, but it is equivalent to use n-p junction dice. First, prepare a red LED chip 401, made by epitaxing a p-type InGaAIP on an n-type GaAs substrate using a traditional technology. A transparent conductive layer 5 with thickness of 200Å to 5000Å, the better of 500Å to 1000Å is sputtered or evaporated to be the positive electrode. By using a first mask to perform lithography and etching away a grove of the transparent conductive layer 5 and the p-type InGaN layer 3 to expose the n-type InGaN 2. Then a thin electrode layer 6 of metal such as Cr, Au or Al with width of 5-20 *µ*m, and thickness of 200 Å to 10000 Å, the better of 500 Å is deposited to be the negative conducting metal 6, also a thick metal strip 902 of aluminum, copper or gold with width of 50 *µ*m to 200 *µ*m, the better of 100 *µ*m and thickness of 1000Å to 40000Å, the better of 10000Å is deposited be the negative bonding pad 902. The negative bonding pad 902 is line up with the positive bonding pad 907 in one side of the chip. On one side of the top, a strip layer of aluminum, copper or gold with width of 100 *µ*m is deposited to be the positive bonding pad R+ 406 of the red LED, The metal layers 407, 902 and 6 prevent the red light emit forward alone to become noise signal, the reflected red light is then reflected upward by the reflective layer 801 and mixed with the green light above it. Conducting metal 6 also conducts current around the chip to reduce the series resistance of the n-type InGaN, so that the driving voltage can be reduced. The thickness of the thin electrode layer 6 is very thin such that scribing along the scribe line will not damage the metal and the n-type crystal. Since in such structure, the p-n junction under the transparent conductive layer 5 keep away from the scribe line, so that the lattice defects induced by scribing will not extraordinary emit lights to form light spots, and the life time of the LED chip will increase, On the bottom of the chip a reflective metal layer 801, with thickness of 1000Å to 20000Å, the better of 2000Å to 5000Å, is sputtered or evaporated. The size of the red LED is about 300 *µ*m to 3000 *µ*m. The red LED is then bond on the pc-board or lead frame by heating to the eutectic point of metal, for example 450 °C to 550 °C or by ultrasonic boding or silver-paste adhesion. The bottom metal 801 is connected to the common ground metal pattern 701 on the pc-board or the lead frame. Then prepare a second green light LED chip 402 which is made by traditional technology, for example, n-type InGaN / p-tpye InGaN on a sapphire 805. A transparent conductive layer 5 with thickness of 200Å to 5000Å, the better of 500Å to 1000Å is sputtered or evaporated to be the positive electrode. By using a first mask to perform lithography and etching away a grove of the transparent conductive layer 5 and the p-type InGaN layer 3 to expose the n-type InGaN 2. Then a thin electrode layer 6 of metal such as Cr, Au or Al with width of 5-20 µ m, and thickness of 200 Å to 10000 Å, the better of 500Å is deposited to be the negative conducting metal 6, also a thick metal strip 902 of aluminum, copper or gold with width of 50 *µ*m to 200 *µ*m, the better of 100 *µ*m and thickness of 1000Å to 40000Å, the better of 10000Å is deposited be the negative bonding pad 902. A strip of positive bonding pad G+ 407 with width of 100 *µ*m is deposited and patterned on one side to be the positive bonding pad of the green light. The negative bonding pad 902 is line up with the positive bonding pad 407 in one side of the chip. The metal layer 902, 407 and 6 are used to reflect the red light back to the reflective layer 801 on the pc-board 405 and reflect upward again to mix with the green light, which can save energy, as shown in FIG. 16 and FIG.17. The green LED 402 is then overlap cascade bonded on the red LED chip 401 by transparent but non-conductive material such as epoxy, polyimide or other transparent materials adhesion. The size of the green LED is about 250 µ m to 2500 µ m.

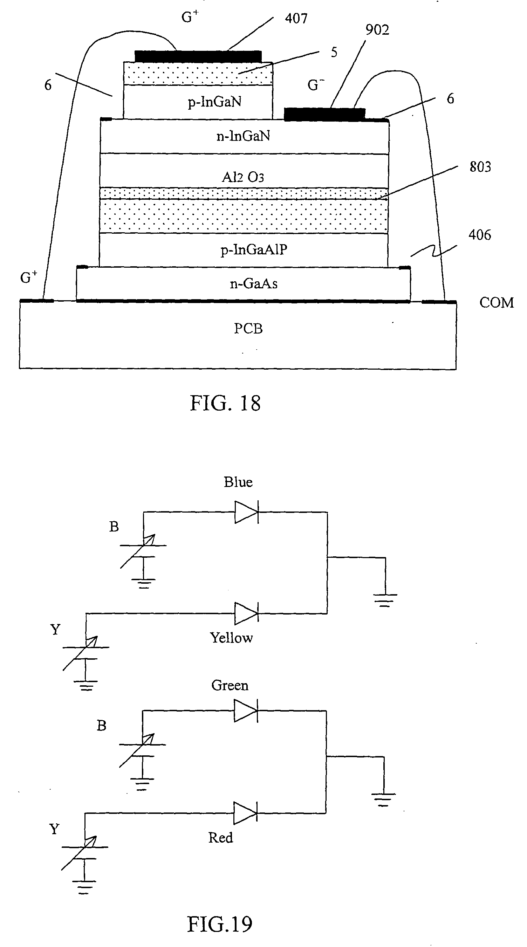

The yellow LED chip 131 and the blue LED 403 is overlap cascade bonded with the same method as that of the red LED chip and the green LED chip in parallel side-by-side as close as possible to the red and green LED, as shown in FIG. 16 and FIG. 17. The size of the yellow LED chip 131 is about 300 *µ*m to 3000 *µ*m. The size of the blue LED chip is about 250 *µ*m to 2500 *µ*m. After the die bond is completed, wire bond is then connect the positive bonding pads R+ 406, G+ 407, B+ 804 and Y+ 134 and the negative bonding pads G- 902, B- 901 of the dice to the positive and negative bonding pad on the pc-board or lead frame respectively. The full color LED is then sealed with transparent plastic material. The equivalent circuit is shown in FIG. 19 for common cathode of p-n junction dice, it is value to notice that in this embodiment, different color is obtained by change the bias of each color to change the current and thus different light intensities are mixed to form different colors as shown in the chromaticity in FIG 2. In this case, along line A-B (yellow to blue) and C-D (red to green), we can adjust the intensity to obtain any color, including white light.

Another embodiment of an overlap cascaded packaging structure full color LED according to the present invention is by using of the left part (the yellow and blue light LED chips in overlap cascaded package) or the right part (the red and green LED chips in overlap cascaded package) independently. By adjusting the bias of each LED and with a constant current to obtain a white light LED luminescence or a full color LED.

The third embodiment does not limit to overlap cascaded package of the yellow and blue LED chips or the red and green LED chips, any two complementary color with which obtain a white light after mixed can be used. The materials used to fabricate the red, green, blue and yellow LEDs are not limited to the above materials, the structure of the diode is not limited to p-n junction structure, those advance technology such as quantum well structure can be used.

Although specific embodiments of the invention have been disclosed, it will be understood by those having skill in the art that minor changes can be made to the form and details of the specific embodiments disclosed herein, without departing from the spirit and the scope of the invention. The embodiments presented above are for purposes of example only and are not to be taken to limit the scope of the appended claims.

## Claims

1. A full color LED packaging structure for overlap bonding in cascade, comprising:
a substrate formed by GaAs, GaP, used as epitaxial substrate;
a p-n junction of light emitted diode, epitaxied on said substrate;
a silicon dioxide film and a reflective metal layer of gold germanium or gold alloy, is formed around the chip to decrease the electric field near the scribe line and formed an open window on the center such that light can emit from said window;
a transparent conductive layer formed on said p-type semiconductor, said silicon dioxide layer and said reflective metal layer such that positive bias voltage is applied to the p-type semiconductor uniformly;
a rectangular bonding pad formed by aluminum, aluminum alloy or gold, is formed on one side of the chip to be the positive bonding pad;
a metal electrode formed on the bottom of said substrate to be a reflecting layer of light and a negative electrode, which may bond to a pc board or a lead frame.

2. The electrode structure of light emitted diode according to claim 1, wherein said silicon dioxide film and said reflective metal layer is replaced by etching a grove around the LED die.

3. The electrode structure of light emitted diode according to claim 1, wherein the width of said silicon dioxide is at least 5-20µm, and the thickness is 200Å to 10000Å.

4. The electrode structure of light emitted diode according to claim 1, wherein the thickness of the reflective metal layer over the silicon dioxide is 200Å to 5000Å, the better is 500Å, and the edge of said open window of said reflective metal layer to the edge of said chip is more than 10µm.

5. A full color LED packaging structure for overlap bonding in cascade, comprising:
a substrate formed by sapphire, used as epitaxial substrate;
a p-n junction of light emitted diode, epitaxied on said substrate; on one side of the chip, a strip of the p-type semiconductor is removed except the positive bias electrode region;
a transparent conductive layer formed on said p-type semiconductor to be the positive electrode such that positive bias voltage is applied to the p-type semiconductor uniformly;
a grove formed by etching away said transparent layer and said p-type semiconductor along the scribe line and the area of negative bonding pad;
a conducting metal layer connected to the negative bonding pad is form on said grove around the scribe line of the chip;
two bonding pads formed by aluminum, aluminum alloy or gold, formed on one side of the chip, the positive bonding pad on the top of the p-type semiconductor is rectangular and the negative bonding pad on the n-type semiconductor is also rectangular.

6. The electrode structure of light emitted diode according to claim 5, wherein the width of transparent conductive layer and p-type semiconductor removed for the negative bonding pad is 50µm to 150µm.

7. The electrode structure of light emitted diode according to claim 5, wherein the width of transparent conductive layer and p-type semiconductor removed along the scribe line is 10µm to 50µm.

8. The electrode structure of light emitted diode according to claim 5, wherein the positive bonding pad and the negative bonding pad are lining up in one side of the chip.

9. The electrode structure of light emitted diode according to claim 5, wherein the positive bonding pad and the negative bonding pad are in the opposite side of the chip.

10. A full color LED packaging structure containing three-primary-color LED dice bond in cascade, by using a reflective metal layer and a transparent layer to overlap bond the red, blue and green LED dice in cascade on a bonding seat, comprising:
(a) a bonding seat, wherein a reflective metal layer is deposited and patterned to form a die bonding pad, a red LED positive bias bonding pad, a blue LED positive bonding pad, a green light positive bonding pad and a common negative bonding pad;
(b) a first red LED die having a transparent conductive layer of positive electrode and a reflective metal layer of negative electrode, the red LED die is directly overlap bonded to the die bonding pad of the bonding seat;
(c) a second blue LED die having a transparent conductive layer positive electrode and a negative electrode with metal layer around the die, the blue LED die is directly overlap bonded in cascade by transparent non-conductive layer on the red LED die;
(d) a third green LED die having a transparent conductive layer positive electrode and a negative electrode with metal layer around the die, the green LED die is directly overlap bonded in cascade by transparent non-conductive layer on the blue LED die;
(e) a plurality of bonding wires for electrically connecting the positive and negative bonding pads of the red LED die, the blue LED die and the green LED die to the positive bonding pads and the common negative bonding pad on the bonding seat respectively.

11. The full color LED packaging structure according to claim 10, wherein the red LED die is a pn-junction diode form by epitaxy a p-type InGaP on an n-type GaAs substrate, the size of the die is 300 µ m to 3000 µ m rectangular.

12. The full color LED packaging structure according to claim 10, wherein a rectangular reflective metal layer is deposited on one side of the transparent positive electrode of the red LED die to form the positive bonding pad of the red LED, and for reflecting the red light.

13. The full color LED packaging structure according to claim 10, wherein the blue LED die is a pn-junction diode form by epitaxy a p-type InGaN/n-type InGaN on a transparent sapphire substrate, the size of the die is 250 *µ*m to 2500 µ m rectangular.

14. The full color LED packaging structure according to claim 10, wherein a strip of reflective metal layer is deposited on one side of the transparent positive electrode of the blue LED die to form a positive bonding pad of the blue LED, and for reflecting the red and blue light, around the blue LED die and the area of the negative bonding pad, a grove of the transparent positive electrode and the p-type InGaN is etch away and a metal layer is deposited to form the negative conductive metal layer around the die.

15. The full color LED packaging structure according to claim 10, wherein the green LED die is a pn-junction diode form by epitaxy an n-type InGaN/p-type InGaN on a transparent sapphire substrate, the size of the die is 200 *µ* m to 2000 µm rectangular.

16. The full color LED packaging structure according to claim 10, wherein a rectangular reflective metal layer is deposited on one side of the transparent positive electrode of the green LED die to form the positive bond pad of the green LED, and for reflecting the red, blue and green light, around the green LED die and the area of the negative bonding pad, a grove of the transparent positive electrode and the p-type InGaN is etch away and a metal layer is deposited to form the negative conductive metal layer around the die.

17. A full color LED packaging structure containing a blue LED die on a yellow LED die in parallel side-by-side with another green LED die on a red LED die, the yellow LED die is bonded to a bonding seat and the blue LED die is overlap bonded in cascade to the yellow LED die, the red LED die is bonded to the bonding seat and the green LED die is overlap cascade bonded to the red LED die, comprising:
(a) a bonding seat, wherein a reflective metal layer is deposited and patterned to form a die bonding pad, a red LED positive bonding pad, a blue LED positive bonding pad, a yellow LED positive bonding pad, a green LED positive bonding pad and a common negative bonding pad;
(b) a first yellow LED die having a transparent conductive layer of positive electrode and a reflective metal layer of negative electrode, the yellow LED die is directly overlap bond to the die bonding pad of the bonding seat;
(c) a second blue LED die having a transparent conductive layer of positive electrode and a negative electrode with metal layer around the die, the blue LED die is directly overlap bonded in cascade by transparent non-conductive layer on the yellow LED die;
(d) a third red LED die having a transparent conductive layer of positive and a reflective metal layer negative electrodes, the red LED die is directly overlap bonded to the die bonding pad of the bonding seat in one side nearby the yellow and blue LED dice;
(e) a fourth green LED die having a transparent conductive layer of positive and a negative electrode with metal layer around the die, the green LED die is directly overlap bonded in cascade by transparent non-conductive layer on the red LED die;
(f) a plurality of bonding wires for electrically connecting the positive and negative bonding pad of the yellow LED die, the blue LED die, the red LED die and green LED die to the positive bonding pads and the common negative bonding pad on the bonding seat respectively.

18. The full color LED packaging structure according to claim 17, wherein the yellow LED die is a pn-junction diode form by epitaxy a p-type InGaAIP on an n-type GaAs substrate, the size of the die is 300 *µ*m to 3000 *µ*m rectangular.

19. The full color LED packaging structure according to claim 17, wherein a rectangular reflective metal layer is deposited on one side of the positive electrode of the yellow LED die to form the positive bonding pad of the yellow LED, and for reflecting the yellow light.

20. The full color LED packaging structure according to claim 17, wherein the blue LED die is a pn-junction diode form by epitaxy a p-type InGaN/n-type InGaN on a transparent sapphire substrate, the size of the die is 250 µ m to 2500 µ m rectangular.

21. The full color LED packaging structure according to claim 17, wherein a rectangular reflective metal layer is deposited on one side of the positive electrode of the blue LED die to form the positive bond pad of the blue LED, and for reflecting the yellow and blue light, around the blue LED die and the area of the negative bonding pad, a grove of the transparent positive electrode and the p-type InGaN is etch away and a metal layer is deposited to form the negative conductive metal layer around the die.

22. The full color LED packaging structure according to claim 17, wherein the red LED die is a pn-junction diode form by epitaxy a p-type InGaAIP on an n-type GaAs substrate, the size of the die is 300 *µ*m to 3000 *µ*m rectangular.

23. The full color LED packaging structure according to claim 17, wherein a rectangular reflective metal layer is deposited on one side of the positive electrode of the red LED die to form the positive bond pad of the red LED, and for reflecting the red light

24. The full color LED packaging structure according to claim 17, wherein the green LED die is a pn-junction diode form by epitaxy a p-type InGaN/n-type InGaN on a transparent sapphire substrate, the size of the die is 250 µm to 2500 *µ* m rectangular.

25. The full color LED packaging structure according to claim 17, wherein a rectangular reflective metal layer is deposited on one side of the positive electrode of the blue LED die to form the positive bond pad of the blue LED, and for reflecting the red and green light, around the blue LED die and the area of the negative bonding pad, a grove of the transparent positive electrode and the p-type InGaN is etch away and a metal layer is deposited to form the negative conductive metal layer around the die.

26. A full color LED packaging structure containing a first LED die and a second complementary LED die, the first LED die is bond to a bonding seat and the second complementary LED die is overlap cascaded bond to the first LED die, comprising:
(a) a bonding seat, wherein a reflective metal layer is deposited and patterned to form a die bonding pad, a first LED positive bonding pad, a second complementary LED positive bonding pad and a common ground bonding pad;
(b) a first LED die having a transparent conductive layer of positive electrode and a reflective metal layer of negative electrode, the first LED die is directly overlap bond to the die bonding pad of the bonding seat;
(c) a second complementary LED die having a transparent conductive layer of positive and a negative electrode with metal layer around the die, the second complementary LED die is directly overlap bond in cascaded on the first_LED die;
(d) a plurality of bonding wires for electrically connecting the positive and negative bonding pads of the first LED die and the second complementary LED die to the positive bonding pads and the negative bonding pad on the bonding seat respectively.

27. The full color LED packaging structure according to claim 10, 17 or 26, wherein the bonding seat is a pc-board.

28. The full color LED packaging structure according to claim 9, 16 or 25, wherein the bonding seat is a lead frame.

29. The full color LED packaging structure according to claim 1, 5, 10, 17 or 26, wherein the reflective metal layer and bonding pad is aluminum, copper or gold, the thickness of this layer is 1000Å to 40000A, the better is 10000Å; the width is 50 µ m to 200 *µ* m, the better is 100 *µ* m; and the edge of said bonding pad keeps a distance from said scribe line more than 10 µ m.

30. The full color LED packaging structure according to claim 1, 1, 5, 10, 17 or 26, wherein the width of said negative conducting metal on the n-type semiconductor is 5 to 50 µ m, the thickness is 200 to 5000Å, the better is 500Å.

31. The full color LED packaging structure according to claim 1, 5, 10, 17 or 26, wherein the transparent conductive layer is Indium oxide (In₂O₃) or other transparent conductive materials, with thickness of 200Å to 10000Å.

32. The full color LED packaging structure according to claim 10, 17 or 26, wherein the transparent non-conductive layer is epoxy.

33. The full color LED packaging structure according to claim 10, 17 or 26, wherein the transparent non-conductive layer polyimide.

34. The full color LED packaging structure according to claim 10, 17 or 26, wherein the transparent non-conductive layer is transparent material.
